# EUROPEAN PATENT APPLICATION

(11) **EP 3 595 006 A1**
(43) Date of publication of application: **15.01.2020**
(21) Application number: 17899551.0
(22) Date of filing: 05.12.2017
(51) Int. Cl.: H01L 23/552, G02F 1/1362

(54) **DISPLAY SUBSTRATE, PREPARATION METHOD THEREFOR AND DISPLAY APPARATUS**

(30) Priority: 10.03.2017 CN 201710143017
(71) Applicant: BOE Technology Group Co., Ltd., Beijing 100015 (CN)
(72) Inventor: SUN, Xuefei, Beijing 100176 (CN); LI, Zhengliang, Beijing 100176 (CN); ZHANG, Bin, Beijing 100176 (CN); CHAN, Yu-Cheng, Beijing 100176 (CN); LIU, Chien Hung, Beijing 100176 (CN)
(74) Representative: Brötz, Helmut
(86) International application number: PCT/CN2017/114555
(87) International publication number: WO 2018/161657

(57) **Abstract**

A display substrate, a preparation method therefor and a display apparatus. The display substrate comprises: a backing substrate (100), a thin film transistor arranged on the backing substrate (100) and a light-shielding layer arranged on the backing substrate (100), the light-shielding layer comprising a first light-shielding layer (200) and a second light-shielding layer (300) in a stacked arrangement, wherein an orthographic projection of an active layer (500) of the thin film transistor on the backing substrate (100) is within an orthographic projection of the light-shielding layer on the backing substrate (100), and the second light-shielding layer (300) comprises nano-particles for absorbing light in a particular wavelength range. The nano-particles may absorb light passing through the first light-shielding layer (200) so as to reduce the issue of an increased leaking current from the thin film transistor caused by light irradiation on the active layer (500), and may also avoid a poor subsequent preparation process for the display substrate caused by section differences as a result of an increased thickness of the first light-shielding layer (200) due to the shielding of the light in the particular wavelength range.

## Description

The present application claims priority to the Chinese patent application No. 201710143017.6, filed on March 10, 2017, the entire disclosure of which is incorporated herein by reference as part of the present application.

### TECHNICAL FIELD

At least one embodiment of the present disclosure relates to a display substrate and a manufacture method thereof, a display device.

### BACKGROUND

When an active layer in a thin film transistor is irradiated with light, photogenerated carriers will increase, which causes problems to the display device, such as a voltage drift, increase of a leakage current and so on. A wavelength band corresponding to blue light has the greatest influence on the active layer, and particularly has a significant influence on the increase of the leakage current of the display device. Generally, in order to solve this problem, a light shielding layer can be provided in an area where the thin film transistor is located to shield light for the active layer. However, in the present process, the arrangement of the light shielding layer still cannot meet the requirements, and problems such as poor process are easily caused.

### SUMMARY

At least one embodiment of the present disclosure provides a display substrate, comprising: a base substrate; a thin film transistor on the base substrate; and a light shielding layer, which comprises a first light shielding layer and a second light shielding layer, on the base substrate, wherein an orthographic projection of an active layer of the thin film transistor on the base substrate is within an orthogonal projection of the light shielding layer on the base substrate, and the second light shielding layer comprises nanoparticles capable of absorbing light in a specific wavelength range.

For example, in the display substrate provided by at least one embodiment of the present disclosure, a material of the first light shielding layer comprises monocrystalline silicon, polycrystalline silicon or amorphous silicon.

For example, in the display substrate provided by at least one embodiment of the present disclosure, a material of the second light shielding layer further comprises silicon nitride or silicon carbide.

For example, in the display substrate provided by at least one embodiment of the present disclosure, a thickness of the first light shielding layer ranges from 400 Å to 600 Å, and a thickness of the second light shielding layer ranges from 200 Å to 500 Å.

For example, in the display substrate provided by at least one embodiment of the present disclosure, the nanoparticles are nano silicon particles.

For example, in the display substrate provided by at least one embodiment of the present disclosure, particle sizes of the nano silicon particles range from 3nm to 5nm.

For example, in the display substrate provided by at least one embodiment of the present disclosure, the light is blue light, and a wavelength of the blue light ranges from 420nm to 480 nm.

For example, in the display substrate provided by at least one embodiment of the present disclosure, the first light shielding layer is on a side of the second light shielding layer that is away from the base substrate; or the second light shielding layer is on a side of the first light shielding layer that is away from the base substrate.

For example, in the display substrate provided by at least one embodiment of the present disclosure, the thin film transistor comprises a thin film transistor of a top gate structure or a thin film transistor of a bottom gate structure.

For example, in the display substrate provided by at least one embodiment of the present disclosure, in a case where the thin film transistor has the bottom gate structure, the light shielding layer is on a side of the active layer that is away from the base substrate; or in a case where the thin film transistor has the top gate structure, the light shielding layer is disposed between the base substrate and the active layer.

At least one embodiment of the present disclosure provides a display device, comprising the display substrate according to any one of the above embodiments.

At least one embodiment of the present disclosure provides a manufacture method of a display substrate, comprising: providing a base substrate; forming a thin film transistor on the base substrate; and forming a light shielding layer, which comprises a first light shielding layer and a second light shielding layer, on the base substrate, wherein an orthographic projection of an active layer of the thin film transistor on the base substrate is within an orthogonal projection of the light shielding layer on the base substrate, and the second light shielding layer comprises nanoparticles capable of absorbing light in a specific wavelength range.

For example, in the manufacture method provided by at least one embodiment of the present disclosure, a method of forming the second light shielding layer comprises spiral wave plasma chemical vapor deposition.

For example, in the manufacture method provided by at least one embodiment of the present disclosure, the nanoparticles are nano silicon particles, and forming the second light shielding layer comprises: forming a second light shielding layer film comprising the nano silicon particles through a reaction gas comprising at least nitrogen, silane and hydrogen, or through a reaction gas comprising at least nitrogen, methane, silane and hydrogen; and performing a patterning process on the second light shielding layer film to form the second light shielding layer comprising the nano silicon particles.

For example, in the manufacture method provided by at least one embodiment of the present disclosure, in a case where the second light shielding layer film is formed through a reaction gas comprising at least nitrogen, methane, silane and hydrogen, process conditions of the spiral wave plasma chemical vapor deposition comprise: a temperature ranging from 650 degrees Celsius to 750 degrees Celsius, power ranging from 400 Watts to 600 Watts, low pressure of pressure being up to 1.33 Pa, and magnetic induction intensity ranging from 90 Gs to 130 Gs.

For example, in the manufacture method provided by at least one embodiment of the present disclosure, the process conditions of the spiral wave plasma chemical vapor deposition comprise: the temperature being 700 degrees Celsius; the pressure being 1.33 Pa, the power being 500 watts; the magnetic induction intensity being 110 Gs and a volume ratio of the hydrogen, methane and silane being 1:2:40.

For example, in the manufacture method provided by at least one embodiment of the present disclosure, the light is blue light, and a wavelength of the blue light ranges from 420nm to 480 nm.

For example, in the manufacture method provided by at least one embodiment of the present disclosure, forming the light shielding layer, which comprises the first light shielding layer and the second light shielding layer, on the base substrate comprises: forming the first light shielding layer on the base substrate; and forming the second light shielding layer on the first light shielding layer.

For example, in the manufacture method provided by at least one embodiment of the present disclosure, the light shielding layer is formed synchronously with the active layer in the thin film transistor, and the method comprises: after a thin film of the light shielding layer and a thin film of the active layer are sequentially formed on the base substrate, using a same mask for the thin film of the light shielding layer and the thin film of the active layer to form the light shielding layer and the active layer.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
Fig. 1 is a cross-sectional structure schematic diagram of a display substrate in an embodiment of the present disclosure;
Fig. 2 is a cross-sectional structure schematic diagram of another display substrate in an embodiment of the present disclosure;
Fig. 3a is a cross-sectional structure schematic diagram of still another display substrate in an embodiment of the present disclosure;
Fig. 3b is a cross-sectional structure schematic diagram of further still another display substrate in an embodiment of the present disclosure;
Figs. 4a-4i are processing diagrams of a manufacture method of a display substrate in an embodiment of the present disclosure; and
Figs. 5a-5g are processing diagrams of another manufacture method of a display substrate in an embodiment of the present disclosure.

### DETAILED DESCRIPTION

In order to make objects, technical details and advantages of the embodiments of the disclosure apparent, the technical solutions of the embodiments of the disclosure will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

In a conventional process, a metal such as molybdenum is generally used as a material of a light shielding layer to shield light for the active layer of the thin film transistor, but parasitic capacitance caused by the metal material may be relatively large. Therefore, for example, amorphous silicon can be used instead of metallic molybdenum to prepare the light shielding layer. Amorphous silicon is a semiconductor material and has small parasitic capacitance in a thin film transistor, which can improve display yield.

However, in the actual process, a thickness of the light shielding layer is limited. Thus, for example, the light shielding layer prepared by amorphous silicon can shield or absorb part of light on a path, and other parts of the light such as part of blue light may still transmit through the light shielding layer. Therefore, the thickness of the light shielding layer needs to be thickened so that a light absorption peak of the light shielding layer can be blue-shifted. Although thickening the thickness of the light shielding layer can make the absorption peak of the light shielding layer blue-shift and reduce the transmittance of other light, the increase of the thickness of the light shielding layer will cause a large step difference, and may further lead to a poor subsequent manufacturing process such as a process of the thin film transistor in a display substrate.

At least one embodiment of the present disclosure provides a display substrate and a manufacture method thereof, a display device. The display substrate comprises a base substrate, a thin film transistor on the base substrate and a light shielding layer on the base substrate. The light shielding layer comprises at least a first light shielding layer and at least a second light shielding layer corresponding to an active layer of the thin film transistor; the second light shielding layer comprises nanoparticles capable of absorbing light in a specific wavelength range. In the embodiments of the present disclosure, for example, a corresponding arrangement of the active layer and the light shielding layer can be: an orthographic projection of the active layer of the thin film transistor on the base substrate is within an orthogonal projection of the light shielding layer on the base substrate, and therefore the light shielding layer can shield the active layer against light in a direction perpendicular to the base substrate.

In light transmitting through the first light shielding layer, blue light has a significant adverse effect on the active layer. Therefore, taking the light in the specific wavelength range being blue light as an example, technical solutions in the following embodiments of the present disclosure will be described.

In the embodiment, the second light shielding layer comprises nanoparticles and can absorb blue light that transmits through the first light shielding layer, and therefore transmittance of blue light can be reduced without increasing the thickness of the first light shielding layer (that is, the light absorption peak of the first light shielding layer can be blue-shifted without increasing the thickness of the first light shielding layer), so that defects in the manufacture processes of devices such as a thin film transistor due to a step difference caused by increasing the thickness of the first light shielding layer can be avoided. For example, the second light shielding layer can be a light absorbing layer. According to quantum size effect, as sizes of quantum dots gradually decrease, a light absorption spectrum of the quantum dots will appear a blue-shift phenomenon. The smaller the sizes are, the more significant the blue-shift phenomenon of the light absorption spectrum is. Taking silicon particles as an example, when particle sizes of the silicon particles are smaller, a band gap corresponding to a system such as a film comprising the silicon particles will be broadened, that is, a wavelength of light that can be absorbed by the system is shorter, which shows the blue shift of the absorption peak, that is, the absorption peak of the second light shielding layer comprising the silicon nanoparticles in the above embodiment is blue-shifted so that all or at least part of the blue light can be absorbed.

Hereinafter, taking the nano silicon particles as the nanoparticles as an example, a display substrate and a manufacture method thereof, a display device according to at least one embodiment of the present disclosure will be described with reference to the accompanying drawings.

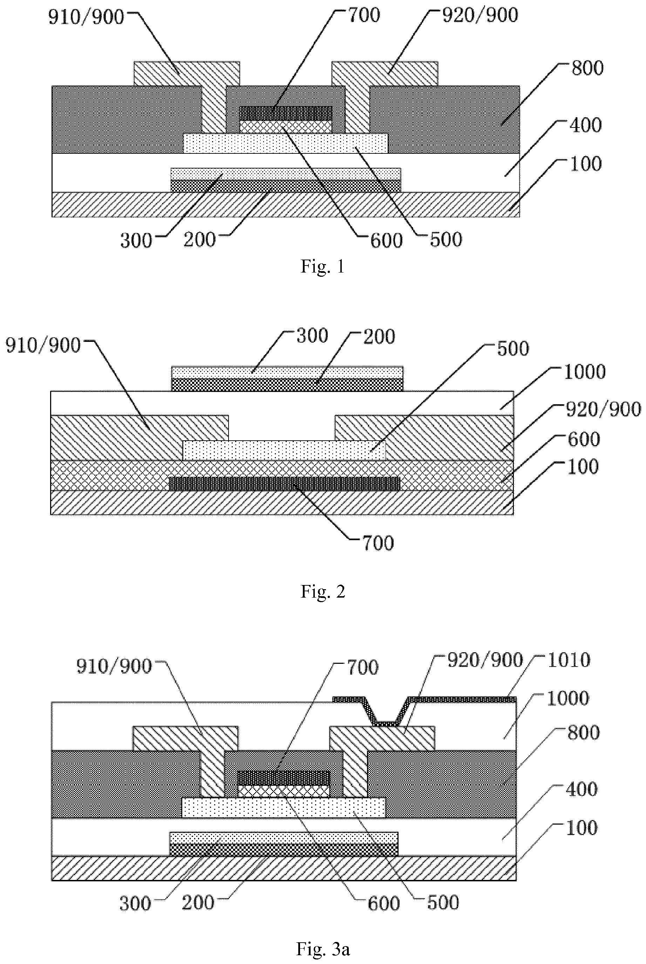

At least one embodiment of the present disclosure provides a display substrate. Fig. 1 is a cross-sectional schematic diagram, which is a sectional view, of a display substrate provided by an embodiment of the present disclosure. For example, as illustrated in Fig. 1, the display substrate comprises a base substrate 100, a thin film transistor on the base substrate 100 and a light shielding layer on the base substrate 100. The light shielding layer is arranged corresponding to an active layer 500 of the thin film transistor, and the light shielding layer comprises at least a first light shielding layer 200 and at least a second light shielding layer 300, the second light shielding layer (for example, a light absorbing layer) 300 comprises nano silicon particles to absorb blue light in a specific wavelength range. The thin film transistor can comprise the active layer 500, a gate insulating layer 600, a gate electrode 700, an insulating layer 800, a source-drain electrode layer 900 and so on, and the source-drain electrode layer 900 comprises a source electrode 910 and a drain electrode 920.

For example, in at least one embodiment of the present disclosure, as illustrated in Fig. 1, a thickness of the first light shielding layer 200 can range from about 400 Å to 600 Å, and a thickness of the second light shielding layer can range from about 200 Å to 500 Å. For example, in a situation where only the first light shielding layer 200 is provided, in order to shield light, particularly the blue light, the thickness of the first light shielding layer 200 ranges from about 1000 Å to 1500 Å, but part of the blue light may still transmit through the first light shielding layer 200 having the thickness in this thickness range. For example, in a situation where the first light shielding layer 200 is provided separately, and the thickness of the first light shielding layer 200 is 1000 Å, but part of the blue light may transmit through the first light shielding layer 200 of this thickness. However, a technical effect of absorbing the blue light that transmits through the first light shielding layer 200 can be achieved by using the first light shielding layer 200 having a thickness of 400 Å and the second light shielding layer 300 having a thickness of 300 Å, and a total thickness of the light shielding layer, which comprises the first light shielding layer 200 and the second light shielding layer 300, is less than the thickness of the first light shielding layer that is provided separately. The step difference is reduced based on the same or better technical effect of filtering blue light, and therefore the adverse effect of the step difference on the subsequent manufacture process of the display substrate is reduced or eliminated, and the yield of the display substrate is significantly improved.

For example, in at least one embodiment of the present disclosure, the second light shielding layer 300 can be configured to absorb blue light in a wavelength range that has the greatest influence on the active layer 500. For example, a wavelength of the blue light ranges from about 420nm to 480 nm. Further, the second light shielding layer 300 can be configured to absorb light in a wavelength range of about 435nm to 450 nm.

For example, in at least one embodiment of the present disclosure, the second light shielding layer 300 absorbs blue light in a wavelength range of 420nm to 480 nm (for example, from 435nm to 450 nm), and particle sizes of the nano silicon particles required can range from about 3nm to 5 nm. It should be noted that the light absorption peak of the second light shielding layer 300 is blue-shifted with the decrease of the particle sizes of the nano silicon particles, and therefore where light in a shorter wavelength range is required to be absorbed, the particle sizes of the nano silicon particles can be, for example, less than 3nm. The embodiments of the present disclosure do not limit a specific shape of the silicon particles. For example, the shape of the silicon particles can be spherical or approximately spherical, and can also be a rod-like shape and so on.

In the embodiment of the present disclosure, an stacking order of the first light shielding layer 200 and the second light shielding layer 300 is not limited, and positions of the first light shielding layer 200 and the second light shielding layer 300 can be interchanged. As illustrated in Fig. 1, for example, the second light shielding layer 300 is on the first light shielding layer 200, that is, the second light shielding layer 300 is on a side of the first light shielding layer 200 that is away from the base substrate 100. For example, the first light shielding layer 200 can also be on the second light shielding layer 300, that is, the first light shielding layer 200 is on a side of the second light shielding layer 300 that is away from the base substrate 100. For example, in a case where the light shielding layer comprises a plurality of first light shielding layers 200 and a plurality of second light shielding layers 300, the first light shielding layer 200 and the second light shielding layer 300 can be alternately stacked.

The embodiment of the present disclosure does not limit a preparing material of the second light shielding layer 300. For example, in at least one embodiment of the present disclosure, the preparing material of the second light shielding layer 300 can further comprise silicon nitride, silicon carbide or the like, as long as the second light shielding layer 300 may be provided with the nano silicon particles satisfying requirements of the above embodiments, and the second light shielding layer 300 can absorb blue light that transmits through the first light shielding layer 200.

For example, in at least one embodiment of the present disclosure, a preparing material of the first light shielding layer 200 can comprise monocrystalline silicon, polycrystalline silicon, amorphous silicon or the like, for example, can further comprise gallium arsenide, gallium aluminum arsenide, indium phosphide, cadmium sulfide, cadmium telluride and the like. For example, amorphous silicon can be used as constituent materials of both the first light shielding layer and the active layer, and both the first light shielding layer and the active layer can be formed by the same one process, and therefore steps of a manufacture process of, for example, the thin film transistor in the display substrate can be reduced. It should be noted that the second light shielding layer 300 provided in the embodiment of the present disclosure can absorb the light that transmits through the first light shielding layer 200, so that the light shielding effect can be achieved without increasing the thickness of the first light shielding layer 200, and therefore the material of the first light shielding layer may not be limited in the embodiments of the present disclosure.

In the embodiments of the present disclosure, a type and a specific structure of the thin film transistor in the display substrate are not limited. For example, in the display substrate provided by at least one embodiment of the present disclosure, the light shielding layer, which comprises the first light shielding layer 200 and the second light shielding layer 300, can be applied to both a thin film transistor of a top gate type and a thin film transistor of a bottom gate type. For the thin film transistors of different types, arrangement positions of the light shielding layer, which comprises the first light shielding layer 200 and the second light shielding layer 300, can be different. For example, in a case where the thin film transistor has a bottom gate structure, the light shielding layer, which comprises the first light shielding layer 200 and the second light shielding layer 300, can be on a side of the active layer 500 that is away from the base substrate. For example, in a case where the thin film transistor has a top gate structure, the light shielding layer, which comprises the first light shielding layer 200 and the second light shielding layer 300, can be disposed between the base substrate 100 and the active layer 500. Hereinafter, a structure of the display substrate will be further described according to the thin film transistors of different types.

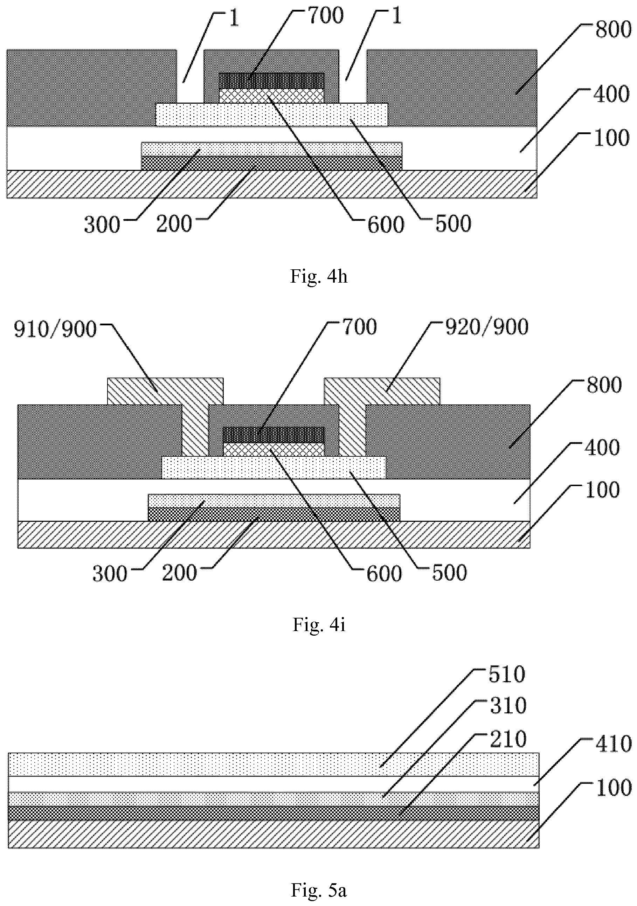

For example, in at least one embodiment of the present disclosure, the thin film transistor in the display substrate is the top gate type thin film transistor. As illustrated in Fig. 1, a light shielding layer comprising at least a first light shielding layer 200 and at least a second light shielding layer 300, an active layer 500, a gate insulating layer 600, a gate electrode 700, an insulating layer 800 and a source-drain electrode layer 900 are sequentially arranged on the base substrate 100, and a source electrode 910 and a drain electrode 920 of the source-drain electrode layer 900 can be electrically connected with the active layer 500 through, for example, via holes (not illustrated in the drawing, referring to via holes 1 in Fig. 4h of the following embodiment). For the top gate type thin film transistor, light from a side of the active layer 500 that is close to the base substrate 100 should be avoided to irradiate the active layer 500, and therefore the light shielding layer, which comprises the first light shielding layer 200 and the second light shielding layer 300, needs to be disposed between the base substrate 100 and the active layer 500.

For example, as illustrated in Fig. 1, the top gate type thin film transistor in the display substrate can further comprise a buffer layer 400. The buffer layer 400 acts as a transition film layer between the base substrate 100 and the active layer 500, which can make the bonding between the active layer 500 and the base substrate 100 more stable, and can prevent harmful impurities, ions and the like in the base substrate 100 from diffusing into the active layer 500.

A preparing material of the buffer layer 400 can comprise silicon oxide (SiOx), silicon nitride (SiNx), silicon oxynitride (SiOxNy) or the like. For example, the buffer layer 400 can also be a single layer structure composed of silicon nitride or silicon oxide, or a double layer or multi-layer structure composed of silicon nitride and silicon oxide.

For example, in at least one embodiment of the present disclosure, the thin film transistor in the display substrate is the bottom gate type thin film transistor. Fig. 2 is a cross-sectional schematic diagram, which is a sectional view, of another display substrate provided by an embodiment of the present disclosure. For example, as illustrated in Fig. 2, a gate electrode 700, a gate insulating layer 600, an active layer 500, a source-drain electrode layer 900, a passivation layer 1000 and a light shielding layer comprising at least a first light shielding layer 200 and a second light shielding layer 300 are sequentially arranged on the base substrate 100, and the source-drain electrode layer 900 comprises a source electrode 910 and a drain electrode 920. For a side of the active layer 500 that is close to the base substrate 100, the gate electrode 700 can play a role of shielding light, but a side of the active layer 500 that is away from the base substrate 100 may be irradiated with light, and therefore the light shielding layer, which comprises the first light shielding layer 200 and the second light shielding layer 300, can be on the side of the active layer 500 that is away from the base substrate 100 so as to shield light for the active layer 500.

For example, in at least one embodiment of the present disclosure, the display substrate can further comprise a first electrode layer that is electrically connected to the source electrode or the drain electrode of the thin film transistor. The display substrate can also comprise other structures of different types, so as to be applied to a liquid crystal display, an organic light emitting diode display, an electronic paper display and so on. Hereinafter, the structure of the display substrate will be further described according to the situations where the thin film transistors in the display substrate are respectively of the top gate type thin film transistors and the bottom gate type thin film transistors.

Fig. 3a is a cross-sectional structure schematic diagram, which is a sectional view, of another display substrate provided by an embodiment of the present disclosure. The thin film transistor in the display substrate has the top gate structure. For example, in at least one embodiment of the present disclosure, as illustrated in Fig. 3a, the display substrate further comprises a passivation layer 1000 and a first electrode layer 1010 on the source-drain electrode layer 900. The first electrode layer 1010 can be, for example, a pixel electrode. The first electrode layer 1010 can be electrically connected to, for example, the drain electrode 920 in the source-drain electrode layer 900 through a via hole (not illustrated in the drawing, referring to the via hole 1 in Fig. 4h) in the passivation layer 1000.

For example, as illustrated in Fig. 3a, the thin film transistor has a top gate structure, and the side of the active layer 500 that is away from the base substrate 100 can be shielded by the gate electrode 700. In order to shield the other side of the active layer 500 from being irradiated by light, a light shielding layer, which comprises the first light shielding layer 200 and the second light shielding layer 300, can be, for example, disposed between the base substrate 100 and the active layer 500. It should be noted that, for example, in a situation where the structure of the gate electrode 700 is limited and the active layer 500 cannot be well shielded by the gate electrode 700, the light shielding layer, which comprises the first light shielding layer 200 and the second light shielding layer 300, can also be on the side of the active layer 500 that is away from the base substrate 100. For example, the first light shielding layer 200 and the second light shielding layer 300 can be on the passivation layer 1000 to shield the active layer 500 from light.

For example, in at least one embodiment of the present disclosure, the display substrate can further comprise a plurality of sub-pixel areas that are arranged in an array, wherein each sub-pixel area can comprise a gate line, a data line, the above-described first electrode layer, the thin film transistor and so on. The gate line and the data line in the display substrate cross each other to define a sub-pixel area, and for example, the data line is electrically connected to, for example, a source electrode in the source-drain electrode layer, and the first electrode layer (a pixel electrode) is electrically connected to, for example, a drain electrode in the source-drain electrode layer.

For example, a preparing material of the passivation layer 1000 can be any one or a combination of silicon nitride (SiNx), silicon oxide (SiOx), an acrylic resin and the like.

For example, the first electrode layer (the pixel electrode) 1010 can be formed of a transparent conductive material or a metal material. For example, a material for forming the first electrode layer 1010 can comprise indium tin oxide (ITO), indium zinc oxide (IZO), indium gallium oxide (IGO), gallium zinc oxide (GZO), zinc oxide (ZnO), indium oxide (In₂O₃), aluminum zinc oxide (AZO), carbon nanotubes and so on.

For example, in at least one embodiment of the present disclosure, the display substrate can further comprise an organic light emitting device, and the first electrode layer 1010 can be an anode or a cathode of the organic light emitting device such as an organic light emitting diode. For example, the organic light emitting device further comprises a second electrode layer 1030 on the first electrode layer 1010 and a light emitting layer 1020 disposed between the first electrode layer 1010 and the second electrode layer 1030. For example, one of the first electrode layer 1010 and the second electrode layer 1030 is an anode, and the other one of the first electrode layer 1010 and the second electrode layer 1030 is a cathode.

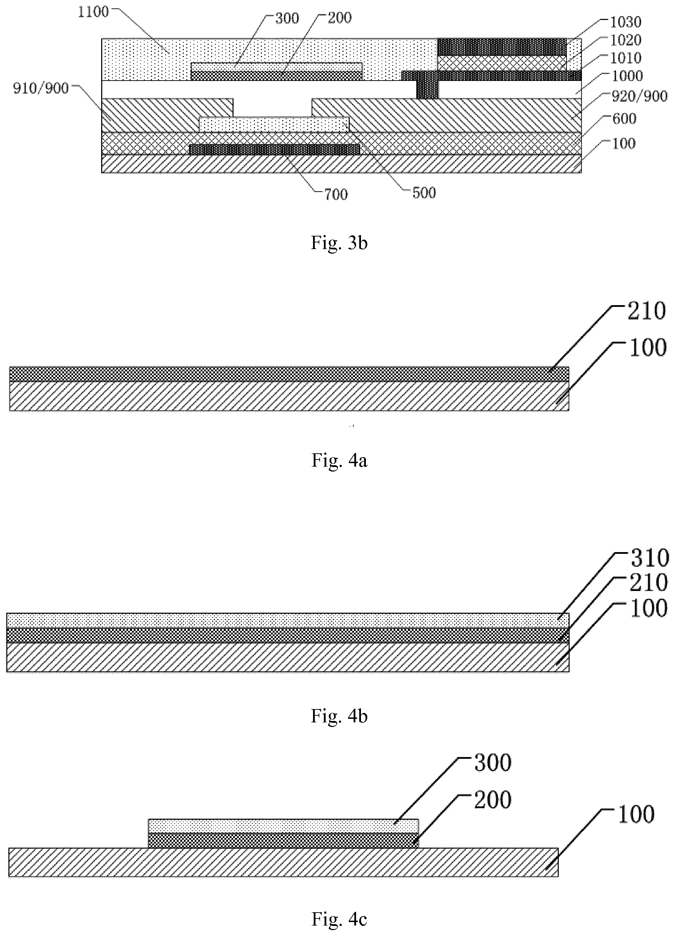

Fig. 3b is a cross-sectional structure schematic diagram, which is a sectional view of further another display substrate provided by an embodiment of the present disclosure. The thin film transistor in the display substrate has a bottom gate structure. For example, in at least one embodiment of the present disclosure, as illustrated in Fig. 3b, the display substrate further comprises a passivation layer 1000 on the source-drain electrode layer 900 and a first electrode layer 1010 that is electrically connected to the drain electrode 920 of the source-drain electrode layer 900. For example, the first electrode layer 1010 is an anode, but the embodiments of the present disclosure are not limited in this aspect. In an embodiment, the display substrate can further comprise a pixel definition layer 1100 and an organic light emitting device on the passivation layer 1000, and the first electrode layer 1010 serves as, for example, an anode or a cathode of the organic light emitting device.

The pixel definition layer 1100 can define a pixel unit area and for example, various partial structures in the organic light emitting device can be formed within the area defined by the pixel definition layer 1100. For example, the organic light emitting device can further comprise a second electrode layer 1030 that is opposite to the first electrode layer 1010 and a light emitting layer 1020 disposed between the first electrode layer 1010 and the second electrode layer 1030. More specifically, the organic light emitting device can further comprise a hole transport layer, a hole injection layer, an electron transport layer and an electron injection layer. For example, an arrangement order of the various structures in the organic light emitting device can be: the anode, the hole injection layer, the hole transport layer, the light emitting layer, the electron transport layer, the electron injection layer and the cathode.

As illustrated in Fig. 3b, the thin film transistor has a bottom gate structure, and a side of the active layer 500 that is close to the base substrate 100 can be shielded from light by the gate electrode 700. In order to shield the other side of the active layer 500 from being irradiated by light, the light shielding layer, which comprises the first light shielding layer 200 and the second light shielding layer 300, can be, for example, on the side of the active layer 500 that is away from the base substrate 100. For example, the light shielding layer can be on a side of the passivation layer 1000 that is away from the active layer 500, or the light shielding layer can also be on a side of the pixel definition layer 1100 that is away from the active layer.

At least one embodiment of the present disclosure provides a display device comprising the display substrate in any of the above embodiments.

For example, in an example of the embodiment of the present disclosure, the display device can be a liquid crystal display panel. For example, the liquid crystal display panel can comprise an array substrate and an opposite substrate, the array substrate and the opposite substrate are oppositely arranged to each other to form a liquid crystal cell, and liquid crystal materials are filled in the liquid crystal cell. The opposite substrate can be, for example, a color filter substrate. A pixel electrode and a common electrode of each pixel unit of the array substrate are used to apply an electric field to control a rotation degree of the liquid crystal materials to perform a display operation.

For example, in an example of the embodiment of the present disclosure, the display device can be an organic light emitting diode (OLED) display panel, wherein a lamination of organic light emitting materials can be formed in a sub-pixel area of the display panel, and a pixel electrode of each sub-pixel unit serves as an anode or a cathode to drive the organic light emitting materials to emit light for the display operation.

For example, in an example of the embodiment of the present disclosure, the display device can be an electronic paper display panel, wherein an electronic ink layer can be formed on the display substrate of the display panel, and a pixel electrode of each sub-pixel unit is used to apply a voltage to drive the charged microparticles in the electronic ink to move, so as to perform a display operation.

For example, the display device can be configured as a display panel having a touch function. For example, the display device can also be applied to any products or components having a display function such as a mobile phone, a tablet computer, a television, a monitor, a notebook computer, a digital photo frame, a navigator and so on.

At least one embodiment of the present disclosure provides a manufacture method of a display substrate. The manufacture method comprises: providing a base substrate; forming a thin film transistor on the base substrate; and forming a light shielding layer, which comprises at least a first light shielding layer and at least a second light shielding layer, corresponding to an active layer of the thin film transistor on the base substrate. The second light shielding layer comprises nanoparticles capable of absorbing light in a specific wavelength range.

For example, in the manufacture method provided by at least one embodiment of the present disclosure, a method of forming the second light shielding layer can comprise spiral wave plasma chemical vapor deposition. High density plasma can be generated by the spiral wave plasma chemical vapor deposition technology under a lower pressure condition, and the generation of plasma generally does not require a high confinement magnetic field. The equipment required in this spiral wave plasma chemical vapor deposition technology is simpler and cost is low. Therefore, the spiral wave plasma chemical vapor deposition technology is more suitable for industrial production of, for example, manufacturing the second light shielding layer comprising silicon nanoparticles.

For example, in the manufacture method provided by at least one embodiment of the present disclosure, the nanoparticles can be nano silicon particles, and a method of forming the second light shielding layer can comprise: forming a second light shielding layer film comprising the nano silicon particles through a reaction gas comprising at least nitrogen, silane and hydrogen; or forming a second light shielding layer film comprising the nano silicon particles through a reaction gas comprising at least nitrogen, methane, silane and hydrogen; and performing a patterning process on the second light shielding layer film to form the second light shielding layer comprising the nano silicon particles.

For example, in the manufacture method provided by at least one embodiment of the present disclosure, particle sizes of the nanoparticles can be adjusted by controlling an injection amount of nitrogen gas.

For example, in the manufacture method provided by at least one embodiment of the present disclosure, the first light shielding layer can be formed on a side of the second light shielding layer that is away from the base substrate; or the second light shielding layer can be formed on a side of the first light shielding layer that is away from the base substrate.

In the display substrate provided by the embodiments of the present disclosure, the thin film transistor can have a bottom gate structure or a top gate structure provided in the above embodiments. Hereinafter, a manufacture process of a display substrate comprising a thin film transistor of one of the bottom gate structure or the top gate structure is provided as an example. For example, an example of the embodiment provides a manufacture process for manufacturing a display substrate comprising the thin film transistor of the top gate structure. Figs. 4a to 4i are process diagrams of a manufacture method of a display substrate provided by an embodiment of the present disclosure. The thin film transistor in the display substrate has a top gate type. Referring to Figs. 4a to 4i, an example of the manufacture method of a display substrate provided by the embodiment comprises the following processes.

As illustrated in Fig. 4a, a base substrate 100 is provided, and a first light shielding layer film 210 is deposited on the base substrate 100.

For example, a preparing material of the base substrate 100 can be transparent glass, ceramic, metal or the like. A preparing material of the first light shielding layer film 210 can be, for example, monocrystalline silicon, polycrystalline silicon or amorphous silicon. For example, the preparing material of the first light shielding layer film 210 can also be gallium arsenide, gallium aluminum arsenide, indium phosphide, cadmium sulfide, cadmium telluride or the like.

As illustrated in Fig. 4b, a second light shielding layer film 310 is deposited on the base substrate 10 on which the first light shielding layer film 210 is formed, and the formed second light shielding layer film 310 comprises nanoparticles. Hereinafter, taking the nanoparticles as nano silicon particles as an example, a process of forming nanoparticles in the second light shielding layer film 310 will be described.

For example, the method of forming the second light shielding layer film 310 can be spiral wave plasma chemical vapor deposition. In the embodiment of the present disclosure, a combination of reaction gases in the spiral wave plasma chemical vapor deposition is not limited, as long as nanoparticles such as nano silicon particles can be formed in the formed second light shielding layer film 310.

For example, the reaction gas of the spiral wave plasma chemical vapor deposition can comprise a mixed gas of nitrogen, silane and hydrogen, and a second light shielding layer film 310 comprising nano silicon particles and having a substrate of silicon nitride can be formed on the base substrate 100.

For example, the reaction gas of the spiral gas plasma chemical vapor deposition can also be a mixed gas comprising nitrogen, methane, silane and hydrogen, and a second light shielding layer film comprising nano silicon particles and having a substrate of silicon carbide can be formed on the base substrate 100.

Particle sizes of the nano silicon particles in the second light shielding layer film 310 can be controlled by controlling an amount of nitrogen gas injected into the reaction gas. For example, in the deposition process, as an injection rate of the injected nitrogen increases, the particle sizes of the formed nano silicon particles are smaller, and the second light shielding layer film 310 can absorb light of a shorter wavelength, that is, the light absorption peak of the second light shielding layer film 310 is blue-shifted with the decrease of the nano silicon particles.

For example, the second light shielding layer film 310 can be formed to absorb blue light having a wavelength ranging from 420 nm to 480 nm, for example, to absorb blue light having a wavelength ranging from 435 nm to 450 nm. For example, blue light in the above wavelength range, for example, in a wavelength range of 435nm to 450 nm, has a large influence on the active layer, and the increase of leakage current of the thin film transistor caused by photogenerated carriers generated after the active layer is irradiated by the blue light in this wavelength range is also more pronounced.

For example, the nano silicon particles have the particle sizes in the range of about 3 nm to 5nm, so that the second light shielding layer film 310 can absorb, for example, blue light having the wavelength ranging from 420 nm to 480 nm, particularly having the wavelength ranging from 435 nm to 450 nm. For example, taking a manufacture process of the second light shielding layer film 310 comprising nano silicon particles and having a substrate of silicon carbide as an example. For example, conditions of forming the second light shielding layer film comprising the nano silicon particles in this size range by the spiral wave plasma chemical vapor deposition technology can be: a temperature ranging from about 650 degrees Celsius to 750 degrees Celsius, a power ranging from about 400 Watts to 600 Watts, low pressure of pressure being up to 1.33 Pa, magnetic induction intensity ranging from about 90 Gs to 130 Gs, and a volume ratio of hydrogen, methane and silane being determined according to a specific requirement of a formed film. For example, a specific example comprises: a temperature of about 700 degrees Celsius; a pressure of about 1.33 Pa, a power of about 500 watts; a magnetic induction intensity of about 110 Gs and a volume ratio of hydrogen, methane and silane being about 1:2:40. By controlling the amount of the nitrogen injected or the injection rate, the nano silicon particles in the second light shielding layer film deposited can meet the requirement that the particle sizes of nano silicon particles are in a range of about 3 nm to 5 nm.

It should be noted that the above particle sizes of the nano silicon particles ranging from 3nm to 5 nm is a basic requirement for the second light shielding layer to absorb blue light, but the particle sizes are not limited to this numerical range. For example, in the above method, nano silicon particles having particle sizes of less than 3nm can also be obtained by changing parameters of the reaction conditions, for example, by injecting more nitrogen gas. In this condition, the requirement of the second light shielding layer 300 to absorb blue light is also satisfied.

For example, a forming order of the second light shielding layer film 310 and the first light shielding layer film 210 can be interchanged, and both the second light shielding layer film 310 and the first light shielding layer film 210 can be multiple layers. For example, the second light shielding layer film 310 and the first light shielding layer film 210 can also be multilayered and overlapped with each other to obtain a laminated layer. In a situation where the two layers are stacked, the stacking order of each second light shielding layer film and each first light shielding layer film can be set arbitrarily.

As illustrated in Fig. 4c, a patterning process is performed by using a same mask on the first light shielding layer film 210 and the second light shielding layer film 310 to form a light shielding layer comprising the first light shielding layer 200 and the second light shielding layer 300.

The patterning process can be, for example, a photolithographic patterning process. For example, the process can comprise: coating a photoresist layer on a structure layer that needs to be patterned; exposing the photoresist layer using a mask; developing the exposed photoresist layer to obtain a photoresist pattern; using the photoresist pattern as a mask to etch the structure layer; and then removing the photoresist pattern optionally.

The formation of the second light shielding layer 300 and the first light shielding layer 200 is not limited to the above patterning process using the same mask. The second light shielding layer film 310 and the first light shielding layer film 210 can also be patterned respectively to form a light shielding layer comprising the second light shielding layer 300 and the first light shielding layer 200.

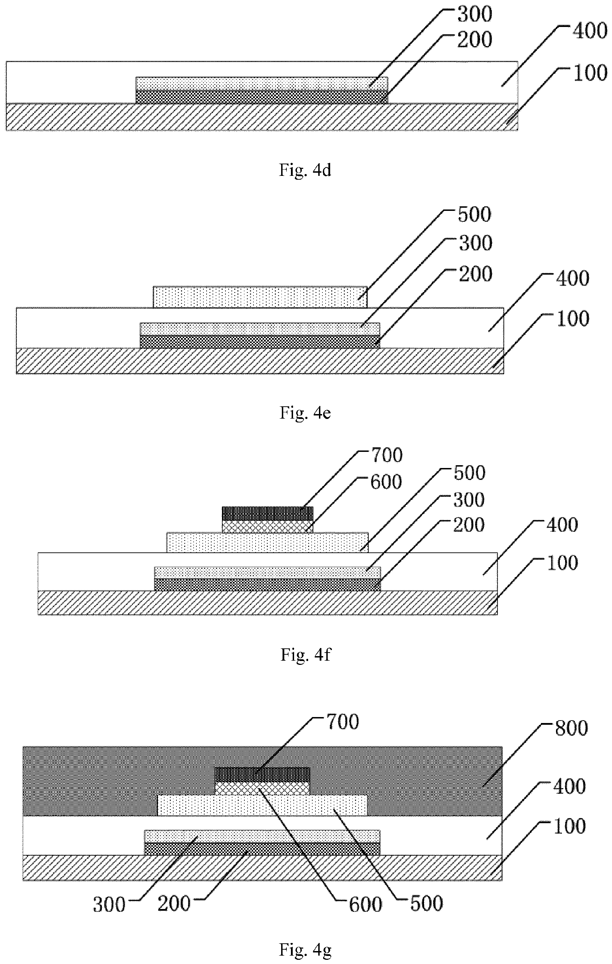

As illustrated in Fig. 4d, a buffer layer 400 is deposited on the base substrate 100 on which the light shielding layer, which comprises the first light shielding layer 200 and the second light shielding layer 300, is formed. The function and the preparing material of the buffer layer 400 are provided in the above embodiments of the present disclosure, and will not be repeated here.

As illustrated in Fig. 4e, a film of a semiconductor material is deposited on the buffer layer 40 and a patterning process is performed on the film of the semiconductor material to form an active layer 500. For example, a preparing material for preparing the active layer 500 comprises amorphous silicon, polycrystalline silicon, and metal oxides such as indium gallium zinc oxide (IGZO), indium zinc oxide (IZO), zinc oxide (ZnO), gallium zinc oxide (GZO) and the like.

As illustrated in Fig. 4f, an insulating material film and a conductive material film are sequentially deposited on the base substrate 100 on which the active layer 500 is formed and a patterning process is performed using a same mask on the two films to form a gate insulating layer 600 and a gate electrode 700, respectively.

For example, a preparing material of the gate insulating layer 600 can comprise silicon nitride (SiNx), silicon oxide (SiOx), aluminum oxide (Al₂O₃), aluminum nitride (A1N) or other suitable materials.

For example, a material of the gate electrode can be a copper-based metal such as copper (Cu), copper-molybdenum alloy (Cu/Mo), copper-titanium alloy (Cu/Ti), copper-molybdenum-titanium alloy (Cu/Mo/Ti), copper-molybdenum-tungsten alloy (Cu/Mo/W), copper-molybdenum-niobium alloy (Cu/Mo/Nb) and the like; the material of the gate electrode can also be chromium-based metal such as chromium-molybdenum alloy (Cr/Mo), chromium-titanium alloy (Cr/Ti), chromium-molybdenum-titanium alloy (Cr/Mo/Ti) and the like; the material of the gate electrode can also be aluminum, aluminum alloy and the like.

The formation of the gate insulating layer 600 and the gate electrode 700 is not limited to the above patterning process using the same mask. The insulating material film and the conductive material film can also be patterned respectively to form the gate insulating layer 600 and the gate electrode 700.

As illustrated in Fig. 4g, a film of insulating material is deposited on the base substrate 100 to form an insulating layer 800. A preparing material of the insulating layer 800 can be silicon nitride (SiNx), silicon oxide (SiOx) or the like.

As illustrated in Fig. 4h, via holes 1 are formed in the insulating layer 800 and the active layer 500 is exposed at the via holes 1.

As illustrated in Fig. 4i, a conductive material film is deposited on the base substrate 100 on which the insulating layer 800 is formed and a patterning process is performed on the conductive material film to form the source-drain electrode layer 900. The source-drain electrode layer 900 comprises a source electrode 910 and a drain electrode 920.

A preparing material of the source-drain electrode layer 900 can be a metal material, and the source-drain electrode layer 900 can be formed as a single layer structure or a multi-layer structure. For example, the source-drain electrode layer 900 can be a single-layer aluminum structure, a single-layer molybdenum structure, or a three-layer structure comprising two molybdenum layers and an aluminum layer between the two molybdenum layers.

In the manufacture method provided by the embodiments of the present disclosure, for example, the light shielding layer and the active layer can be formed synchronously using the same mask, and therefore the process steps are reduced. For example, the manufacture process can be: after the light shielding layer (for example, the first light shielding layer 200 and the second light shielding layer 300), the buffer layer 400 and the active layer 500 are sequentially deposited, the active layer 500 is exposed by using a mask, and then processes of etching and stripping for the light shielding layer and the active layer 500 are completed, and therefore a masking process of the light shielding layer is reduced.

Figs. 5a-5g are processing diagrams of another manufacture method of a display substrate in an embodiment of the present disclosure. Referring to Figs. 5a to 5g, an example of the manufacture method of a display substrate provided by the embodiment can comprise the following steps.

As illustrated in Fig. 5a, a base substrate 100 is provided, and a first light shielding layer film 210, a second light shielding layer film 310, a buffer layer film 410 and a semiconductor material film 510 are sequentially deposited on the base substrate 100.

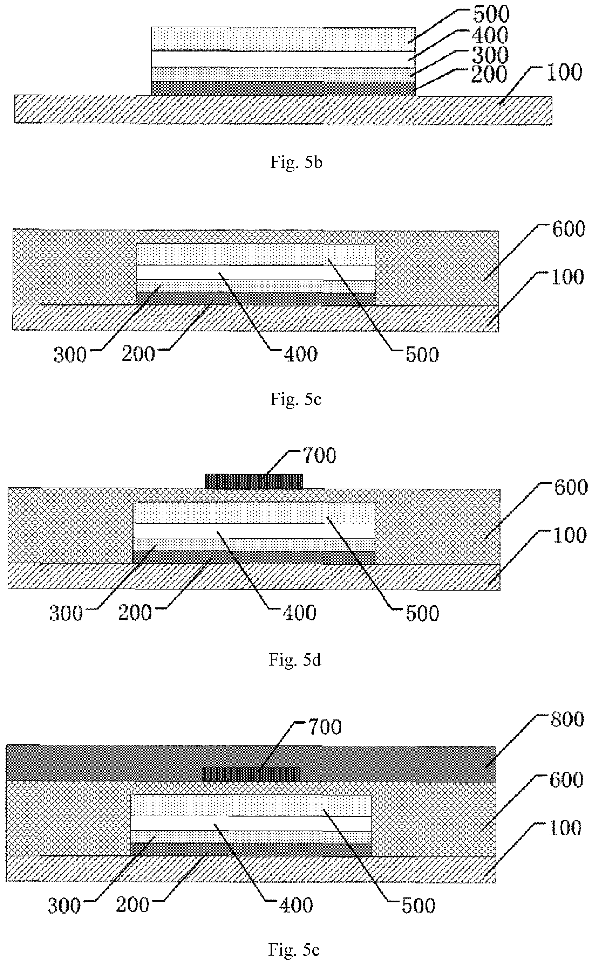

As illustrated in Fig. 5b, a patterning process is performed by using one mask on the first light shielding layer film 210, the second light shielding layer film 310, the buffer layer film 410 and the semiconductor material film 510 to form a light shielding layer comprising a first light shielding layer 200 and a second light shielding layer 300, a buffer layer 400 and an active layer 500.

As illustrated in Fig. 5c, a gate insulating layer 600 is deposited on the base substrate 100 on which the active layer 500 is formed.

As illustrated in Fig. 5d, a conductive material film is deposited on the base substrate 100 on which the gate insulating layer 600 is formed and a patterning process is performed on the conductive material film to form a gate electrode 700.

As illustrated in Fig. 5e, an insulating layer film is deposited on the base substrate 100 to form an insulating layer 800.

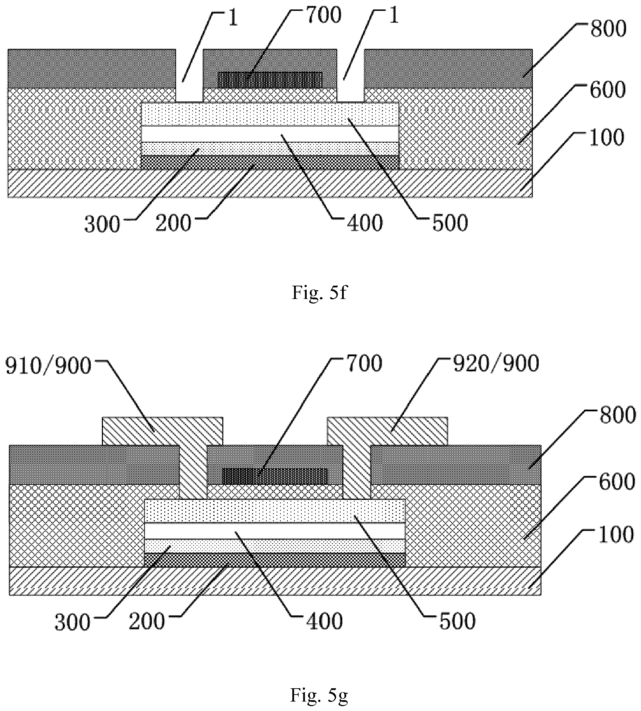

As illustrated in Fig. 5f, via holes 1 are formed in the insulating layer 800 and the gate insulating layer 600, and the active layer 500 is exposed at the via holes 1.

As illustrated in Fig. 5g, a conductive material film is deposited on the base substrate 100 on which the insulating layer 800 is formed and a patterning process is performed on the conductive material film to form the source-drain electrode layer 900. The source-drain electrode layer 900 can comprise a source electrode 910 and a drain electrode 920.

In the example illustrated in Figs. 5a to 5g, materials, structures and related processes of the various layer structures in the manufacture method of the display substrate can be referred to the manufacture method in the example illustrated in Figs. 4a to 4i, and details are not repeated here. It should be noted that the above examples only illustrate the manufacture process of the display substrate in a situation where the thin film transistor has a top gate structure. In a situation where the thin film transistor has a bottom gate structure, a manufacture method of various layer structures in the display substrate is similar to the above manufacture method of a display substrate in which the thin film transistor has a bottom gate type. For example, a manufacture method of each structure in the thin film transistor can be the same as a conventional process, except that the light shielding layer, which comprises the first light shielding layer and the second light shielding layer, needs to be formed on a side of the active layer that is away from the base substrate, as long as the formed first light shielding layer and the second light shielding layer can shield the active layer from light.

At least one embodiment of the present disclosure provides a display substrate and a manufacture method thereof, a display device, which can have at least one of the following advantageous effects:
(1) At least one embodiment of the present disclosure provides a display substrate, and a second light shielding layer provided in the display substrate can absorb light in a specific wavelength range, for example, blue light, and therefore the increase of leakage current of the display device caused by the increase of photogenerated carriers generated after the active layer is irradiated by the blue light can be prevented.
(2) In the display substrate provided by at least one embodiment of the present disclosure, because the second light shielding layer can absorb light in a specific wavelength range, for example, blue light, there is no need to increase the thickness of the first light shielding layer to make the absorption peak of the first light shielding layer be blue-shifted, and the defect of the subsequent manufacture process of the display substrate due to the large step difference caused by the thickening of the first light shielding layer is ameliorated.
(3) At least one embodiment of the present disclosure provides a manufacture method of a display substrate. In the method, the light shielding layer, which comprises the first light shielding layer and the second light shielding layer, and the active layer can be formed in the same masking process, and the process steps are reduced and the cost is reduced.

For the present disclosure, the following several points should be noted:
(1) The accompanying drawings in the embodiments of the present disclosure involve only the structure(s) in connection with the embodiment(s) of the present disclosure, and other structure(s) can be referred to common design(s).
(2) For the purpose of clarity only, in accompanying drawings for illustrating the embodiment(s) of the present disclosure, the thickness of a layer or a area may be enlarged or narrowed, that is, the drawings are not drawn in a real scale.
(3) In case of no conflict, the embodiments of the present disclosure and the features in one embodiment(s) can be combined with each other to obtain new embodiment(s).

What have been described above are merely specific implementations of the present disclosure, but the protection scope of the present disclosure is not limited thereto. The protection scope of the present disclosure should be based on the protection scope of the claims.

## Claims

1. A display substrate, comprising:
a base substrate;
a thin film transistor on the base substrate; and
a light shielding layer on the base substrate, the light shielding layer comprising a first light shielding layer and a second light shielding layer that are stacked,
wherein an orthographic projection of an active layer of the thin film transistor on the base substrate is within an orthogonal projection of the light shielding layer on the base substrate, and the second light shielding layer comprises nanoparticles capable of absorbing light in a specific wavelength range.

2. The display substrate according to claim 1, wherein a material of the first light shielding layer comprises monocrystalline silicon, polycrystalline silicon or amorphous silicon.

3. The display substrate according to claims 1 or 2, wherein a material of the second light shielding layer further comprises silicon nitride or silicon carbide.

4. The display substrate according to any one of claims 1-3, wherein a thickness of the first light shielding layer ranges from 400 Å to 600 Å, and a thickness of the second light shielding layer ranges from 200 Å to 500 Å.

5. The display substrate according to any one of claims 1-4, wherein the nanoparticles are nano silicon particles.

6. The display substrate according to claim 5, wherein particle sizes of the nano silicon particles range from 3nm to 5nm.

7. The display substrate according to any one of claims 1-6, wherein the light is blue light, and a wavelength of the blue light ranges from 420nm to 480 nm.

8. The display substrate according to any one of claims 1-7, wherein the first light shielding layer is on a side of the second light shielding layer that is away from the base substrate; or
the second light shielding layer is on a side of the first light shielding layer that is away from the base substrate.

9. The display substrate according to any one of claims 1-8, wherein the thin film transistor comprises a thin film transistor of a top gate structure or a thin film transistor of a bottom gate structure.

10. The display substrate according to claim 9, wherein in a case where the thin film transistor has the bottom gate structure, the light shielding layer is on a side of the active layer that is away from the base substrate; or
in a case where the thin film transistor has the top gate structure, the light shielding layer is disposed between the base substrate and the active layer.

11. A display device, comprising the display substrate according to any one of claims 1-10.

12. A manufacture method of a display substrate, comprising:
providing a base substrate;
forming a thin film transistor on the base substrate; and
forming a light shielding layer, which comprises a first light shielding layer and a second light shielding layer, on the base substrate,
wherein an orthographic projection of an active layer of the thin film transistor on the base substrate is within an orthogonal projection of the light shielding layer on the base substrate, and the second light shielding layer comprises nanoparticles capable of absorbing light in a specific wavelength range.

13. The manufacture method of a display substrate according to claim 12, wherein a method of forming the second light shielding layer comprises spiral wave plasma chemical vapor deposition.

14. The manufacture method of a display substrate according to claims 12 or 13, wherein the nanoparticles are nano silicon particles, and forming the second light shielding layer comprises:
forming a second light shielding layer film comprising the nano silicon particles through a reaction gas comprising at least nitrogen, silane and hydrogen, or through a reaction gas comprising at least nitrogen, methane, silane and hydrogen; and
performing a patterning process on the second light shielding layer film to form the second light shielding layer comprising the nano silicon particles.

15. The manufacture method of a display substrate according to claim 14, wherein in a case where the second light shielding layer film is formed through the reaction gas comprising at least nitrogen, methane, silane and hydrogen,
process conditions of the spiral wave plasma chemical vapor deposition comprise: a temperature ranging from 650 degrees Celsius to 750 degrees Celsius, power ranging from 400 Watts to 600 Watts, low pressure of pressure being up to 1.33 Pa, and a magnetic induction intensity ranging from 90 Gs to 130 Gs.

16. The manufacture method of a display substrate according to claim 15, wherein the process conditions of the spiral wave plasma chemical vapor deposition comprise: the temperature being 700 degrees Celsius; the pressure is 1.33 Pa, the power being 500 watts; the magnetic induction intensity being 110 Gs and a volume ratio of the hydrogen, methane and silane being 1:2:40.

17. The manufacture method of a display substrate according to any one of claims 12-16, wherein the light is blue light, and a wavelength of the blue light ranges from 420nm to 480 nm.

18. The manufacture method of a display substrate according to any one of claims 12-16, wherein forming the light shielding layer, which comprises the first light shielding layer and the second light shielding layer, on the base substrate comprises:
forming the first light shielding layer on the base substrate; and
forming the second light shielding layer on the first light shielding layer.

19. The manufacture method of a display substrate according to claim 18, wherein the light shielding layer is formed synchronously with the active layer in the thin film transistor, and the method comprises:
after a thin film of the light shielding layer and a thin film of the active layer are sequentially formed on the base substrate, using a same mask for the thin film of the light shielding layer and the thin film of the active layer to form the light shielding layer and the active layer.
